# EUROPEAN PATENT APPLICATION

(11) **EP 1 253 712 A1**
(43) Date of publication of application: **30.10.2002**
(21) Application number: 00978008.1
(22) Date of filing: 29.11.2000
(51) Int. Cl.: H03H 3/10

(54) **ACOUSTIC WAVE DEVICE**

(71) Applicant: MITSUBISHI DENKI KABUSHIKI KAISHA, Chiyoda-ku Tokyo 100-8310 (JP)
(72) Inventor: YOSHIDA, Kenji Mitsubishi Denki Kabushiki Kaisha, Chiyoda-ku Tokyo 100-8310 (JP); MISU, Koichiro Mitsubishi Denki Kabushiki Kaisha, Chiyoda-ku Tokyo 100-8310 (JP); IBATA, Koji Mitsubishi Denki Kabushiki Kaisha, Chiyoda-ku Tokyo 100-8310 (JP); SAKAI, Atsushi Mitsubishi Denki Kabushiki Kaisha, Chiyoda-ku Tokyo 100-8310 (JP); NAGATSUKA, T. Mitsubishi Denki Kabushiki Kaisha, Chiyoda-ku Tokyo 100-8310 (JP); YAMADA, Akira Mitsubishi Denki Kabushiki Kaisha, Chiyoda-ku Tokyo 100-8310 (JP); MAEDA, Chisako Mitsubishi Denki Kabushiki Kaisha, Chiyoda-ku Tokyo 100-8310 (JP)
(74) Representative: Pfenning, Meinig & Partner
(86) International application number: JP0008427
(87) International publication number: WO02045262

(57) **Abstract**

In an elastic wave device in which electrodes including interdigital transducers 4 and 5 made of a conductive material are formed on a piezoelectric substrate 1, a dielectric thin film 8 including silicon oxide as its main component is deposited on the interdigital transducers 4 and 5 and a reflector 9 and the thickness of this dielectric thin film 8 is appropriately set. By appropriately setting the thickness of the dielectric thin film 8, it becomes possible to obtain an elastic wave device that is not required to be hermetically sealed in a package for the sake of protecting the electrodes from minute metallic dusts and avoiding influences from the outside.

## Description

### TECHNICAL FIELD

The present invention relates to an elastic wave device that is used in a circuit, which is contained in a communication equipment or an electronic equipment, or the like, to propagate an elastic wave.

### BACKGROUND ART

Up to this time, as a substrate of an elastic wave device, there has been used a piezoelectric substrate made of lithium niobate (hereinafter referred to as LiNbO₃) having a large electromechanical coupling coefficient K², lithium tantalate (hereinafter referred to as LiTaO₃) that has an electromechanical coupling coefficient K² smaller than that of LiNbO₃ but has a temperature characteristic superior to LiNbO₃, quartz having a zero temperature characteristic, lithium tetraborate (hereinafter referred to as Li₂B₄O₇) having an electromechanical coupling coefficient K² and a temperature characteristic whose values are intermediate between those of LiTaO₃ and quartz, or the like. Alternatively, there may be used a non-piezoelectric substrate made of glass, sapphire, silicon (Si), gallium arsenide (GaAs), diamond, or the like, or a member obtained by depositing a piezoelectric thin film made of zinc oxide (ZnO), aluminum nitride (AlN), cadmium sulfide (CdS), or the like on a non-piezoelectric thin film. Also, in recent years, as new piezoelectric materials, attention has been directed toward potassium niobate (KNbO₃) having a cut angle that exhibits an electromechanical coupling coefficient K² for an elastic surface wave, langasite (La₃Ga₅SiO₁₄), langanite (La₃Ga₅NbO₁₄), and langatate (La₃Ga₅TaO₁₄). The langasite, langanite, and langatate belong to a so-called langasite family and are expected as materials of a substrate for an IF filter. However, in this specification, substrates made of these materials are collectively referred to as piezoelectric substrates except for the case where it is required to distinguish between these materials.

An elastic wave device is constructed by forming interdigital transducers and reflection electrodes, which are made of Al or an alloy including Al as its main ingredient, lead-out electrodes for connecting wires or bumps for inputting electric power into the interdigital transducers or outputting electric power from the interdigital transducers, lead-around electrodes (also called bus bar electrodes) for connecting respective electrodes, and the like on any of the piezoelectric substrates described above using a photolithography technique. By further sealing this elastic wave device in a ceramic package or the like, there is obtained an actual product.

As described above, an elastic wave device is constructed by forming electrode patterns including interdigital transducers on a piezoelectric substrate. Until now, various attempts have been made to improve the characteristics of the elastic wave device by depositing a thin film on the piezoelectric substrate on which these electrode patterns have been formed. In more detail, for instance, attempts have been made to improve the temperature characteristic of the elastic wave device, to protect the interdigital transducers and reflection electrodes from mechanical damage, to prevent the pyroelectric breakdown of electrode fingers, to increase an electromechanical coupling coefficient K², to improve the electric power resistance of the electrode fingers, to improve the moisture resistance of the electrodes, and to prevent shorts between electrode fingers.

In an ordinary elastic wave device, electrode patterns including interdigital transducers are formed on a piezoelectric substrate. This elastic wave device is sealed in a package under a condition where the electrode patterns on the surface of the substrate are not protected and are exposed.

In recent years, the communication frequency band in mobile wireless communications using such an elastic wave device covers a GHz band. In the GHz band, the sizes of the interdigital transducers or reflection electrodes of the elastic wave device are reduced to a submicron order. This means that the spaces between adjacent electrode fingers of the interdigital transducers or reflection electrodes are extremely narrowed. As a result, there is an increased possibility that shorts between adjacent electrode fingers are caused even by minute metallic dusts that have hitherto caused no problems. Also, a surface acoustic wave propagates on the surface of a piezoelectric substrate, so that this wave is extremely sensitive to the condition of the piezoelectric substrate surface. Consequently, in the case where moisture intrudes into a package and water adheres to the piezoelectric substrate surface as a result of condensation, the characteristics of the elastic wave device are degraded. Further, in the case where moisture intrudes into a package, there occurs corrosion of electrodes made of Al or an alloy including Al as its main ingredient because Al is susceptible to moisture. Consequently, the characteristics of the elastic wave device are degraded. To avoid the aforementioned influences from the outside of the elastic wave device, the elastic wave device is highly hermetically sealed in a package.

However, even if an elastic wave device is highly hermetically sealed in a package, there still exists the possibility that minute metallic dusts or moisture intrudes into the package during the process for manufacturing the elastic wave device. Consequently, it is required to protect electrodes in some way. To do so, there may be devised a structure where an electrode protective film is deposited on the interdigital transducers.

Japanese Patent Laid-Open No. 61-136312 (hereinafter referred to as "Document 1") proposes a surface acoustic wave device having a structure where an insulating film made of an oxide such as SiO₂, a nitride such as SiN₂, or their complex is deposited on a surface of a surface acoustic wave element, that is, on a piezoelectric substrate on which interdigital transducers and other electrodes have been formed. With this structure, the interdigital transducer portions are covered and the surface of this insulating film is flattened, thereby preventing mechanical damages and contamination of the electrodes. There is simultaneously realized the prevention of electrode corrosion.

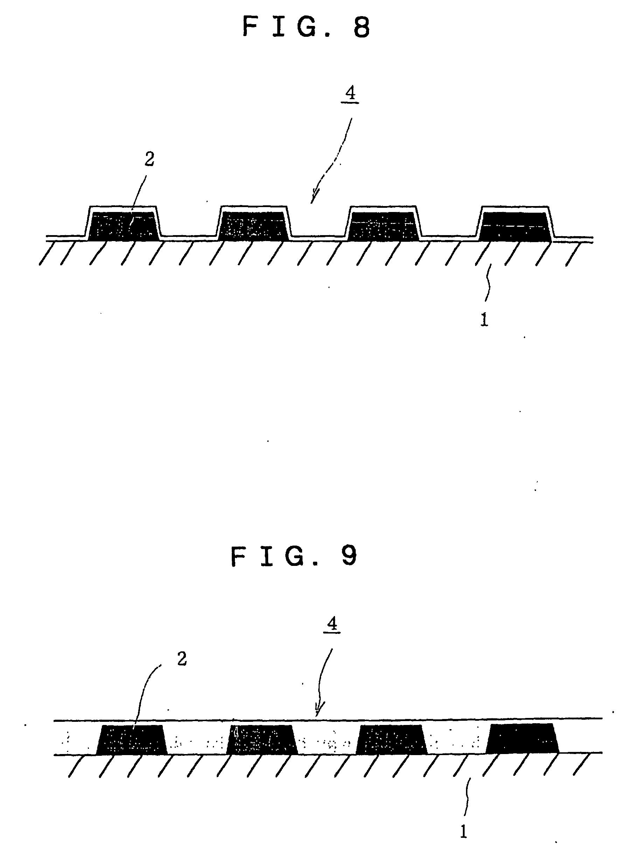

In actuality, however, in the case where a thin film is deposited on interdigital transducers and reflector electrodes, the surface is placed in an uneven condition as shown in FIG. 8. Note that under this condition, as a result of influences of the flattening of side surfaces of the electrodes, there is weakened the effect of preventing an inter-electrode short phenomenon. As a result, in Document 1, the insulating film is deposited so as to fill in the steps formed by the interdigital transducers. That is, as shown in FIG. 9, the surface of the insulating film 8 is flattened, thereby making it possible to obtain a sufficient insulating property. Note that in FIGs. 8 and 9, reference numeral 1 denotes a piezoelectric substrate, numeral 2 an electrode finger, and numeral 4 an input side interdigital transducer that is formed by the electrode fingers 2 and performs the energy conversion of from an electricity to a surface acoustic wave. Note that an output side interdigital transducer that performs the energy conversion from a surface acoustic wave to electricity is constructed in the same manner as this input side interdigital transducer 4.

Also, in Document 1, it is difficult to obtain a sufficient effect of preventing the short-circuiting phenomenon occurring between electrodes if the thickness of the insulating film becomes below 500 Å. On the other hand, if the thickness of the insulating film exceeds 3000 Å, a resonant resistance of the surface acoustic wave element is increased, which results in the degradation of the characteristics of the surface acoustic wave element. Therefore, the preferable thickness of the insulating film deposited on the interdigital transducers is set in a range of from 500 to 3000 Å.

In an elastic wave device having the structure where a thin film is deposited on a piezoelectric substrate like in Document 1, silicon oxide is often used as an insulating film.

Also, in usual cases, silicon oxide has a temperature characteristic coefficient having a sign opposite to that of a substrate used for an elastic wave device. Therefore, attempts have been made to improve the temperature characteristic by depositing the silicon oxide as a thin film on the substrate.

However, the thickness of a silicon oxide film that is required in this case needs to be very thick and be set so as to be around 0.2 times of the wavelength of a surface acoustic wave. Assuming that the speed of a surface acoustic wave is 4000 m/s and the operating frequency of the elastic wave device is 2 GHz, the thickness of the silicon oxide film becomes 0.4 µm. However, if a silicon oxide film having this thickness is deposited on an elastic wave device, the resonant resistance of the elastic wave device is increased and the characteristics thereof are degraded. Consequently, in reality, there is not yet realized an elastic wave device whose temperature characteristic is improved by depositing a silicon oxide film on the elastic wave device.

The electrode patterns formed on the piezoelectric substrate are made of Al or an alloy including Al as its main ingredient and therefore are susceptible to moisture. Also, the silicon oxide film that is often used as an electrode protective film is also inferior in moisture resistance. Note that a silicon nitride film is generally known as a protective film for preventing the corrosion of Al. However, in the case where this silicon nitride film is deposited directly on a piezoelectric substrate, there occurs a problem that the silicon nitride film is cracked if the thickness of the silicon nitride film exceeds a certain level because the coefficient of linear expansion of the piezoelectric substrate differs from that of the silicon nitride film.

To improve the situation described above, JP 8-97671A (hereinafter referred to as "Document 2") proposes a structure where a two-layered protective film including an inner protective film made of silicon oxide and an outer protective film made of silicon nitride is deposited on a substrate on which interdigital transducers have been formed. With this structure, the silicon oxide is inserted as an intermediate layer between a piezoelectric substrate and silicon nitride, thereby realizing smooth changing of the coefficient of linear expansion in a direction from the substrate to the outer protective film. In this manner, there is prevented a situation where the outer protective film is cracked. Document 2 also describes that by adopting this structure, it becomes possible to realize an elastic wave device that is superior in moisture resistance.

As described above, the silicon oxide film has poor moisture resistance, so that it has been conceived that it is difficult to realize an elastic wave device that has superior moisture resistance only with the silicon oxide film.

An elastic wave device is applied to a mobile communication equipment, so that it is required to reduce the size and weight of the device. As to the size of the elastic wave device, the minimum size of a substrate to be used is around 1 mm by 1.5 mm, although it is required to contain the substrate in a package of the elastic wave device. Consequently, the size of the final product becomes 2 mm by 2.5 mm even at the minimum level. Also, the most commonly manufactured products have a size of around 3 mm by 3 mm.

Here, the problems of the related arts described above are summarized as follows.

In Document 1, the preferable thickness of an insulating film deposited on an elastic wave device, in which electrode patterns including interdigital transducers and reflectors have been formed on a piezoelectric substrate, is set in a range of from 500 to 3000 Å. However, in a GHz band in which the recent elastic wave devices are used, changes of a center frequency and a resonant resistance are increased if the thickness of an insulating film is set in the range described in Document 1, which results in a problem that characteristics of the elastic wave device are degraded.

Also, in Document 1 described above, an insulating film is deposited only on interdigital transducers, although reflector electrodes also have electrode finger width that is approximately the same as that of the interdigital transducers. Therefore, if the reflector electrodes are exposed, there exists the possibility that shorts are caused by minute metallic dusts between electrode fingers or that the corrosion of the electrode fingers occurs due to moisture.

Also, Document 2 describes that it becomes possible to realize an elastic wave device that is superior in moisture resistance by depositing two thin films of silicon oxide and silicon nitride on a piezoelectric substrate on which electrode patterns including interdigital transducers and reflectors have been formed. However, because a two-layered thin film is deposited on a piezoelectric substrate, there occur many problems. For instance, it becomes further difficult to adjust film thicknesses and to make film qualities uniform, in comparison with the case of a single-layered thin film. Also, manufacturing costs are increased.

The present invention has been made to solve the problems described above. In an elastic wave device in which electrodes including interdigital transducers made of a conductive material are formed on a piezoelectric substrate, a dielectric thin film including silicon oxide as its main ingredient is deposited on the interdigital transducers and reflectors by appropriately setting the thickness of this dielectric thin film. By appropriately setting the thickness of the dielectric thin film, it also becomes possible to obtain an elastic wave device that is not required to be highly hermetically sealed in a package for the sake of protecting the electrodes from minute metallic dusts and avoiding influences from the outside.

### DISCLOSURE OF THE INVENTION

An elastic wave device according to the present invention is an elastic wave device in which electrodes including interdigital transducers made of a conductive material are formed on a piezoelectric substrate, comprising a dielectric thin film formed on the interdigital transducers, the dielectric thin film having a thickness of from 100 to 1000 Å and including silicon oxide as its main ingredient. By constructing the elastic wave device in this manner, it becomes possible to maintain a coating property and to suppress the increase of the insertion loss of a surface acoustic wave (hereinafter referred to as the "SAW") filter.

Also, it is preferable that the thickness of the dielectric thin film is in a range of from 100 to 500 Å. By setting the thickness in this manner, it becomes possible to reproduce the original characteristics of a SAW filter and to suppress the variations in a center frequency.

Also, it is more preferable that the thickness of the dielectric thin film is in a range of from 200 to 500 Å. By setting the thickness in this manner, the coating ratio of side surfaces of the electrodes is improved, which makes it possible to further improve moisture resistance.

Also, the dielectric thin film may be formed with any one of a CVD method and a sputtering method. In this case, the moisture resistance performance attained is almost the same regardless of which method is used, and there is obtained a dielectric thin film that is superior to that produced with a coating method. Also, when the CVD method and the sputtering method are compared with each other, the CVD method is suited to producing the dielectric thin film at a lower manufacturing cost.

Also, it is possible to deposit the dielectric thin film by placing the piezoelectric substrate or a substrate including a piezoelectric thin film so as to be inclined with respect to a sputtering target and by sputtering the dielectric thin film from a direction that is inclined with respect to a direction vertical to the surface of the substrate. In this manner, it becomes possible to improve the adhesion ratio of the dielectric thin film to side surfaces of the electrodes.

Also, it is preferable that electrode fingers that are made of a conductive material and constitute the electrodes including the interdigital transducers have a cross-sectional shape that is a trapezoid when taken along a plane that is parallel to the direction vertical to the surface of the substrate, and in a direction vertical to a crossing width direction thereof. With this structure, the coating ratio of the electrode fingers with the dielectric thin film is improved, thereby making it possible to realize an elastic wave device that is further superior in moisture resistance.

### BRIEF DESCRIPTION OF THE DRAWINGS

FIG. 1 is a plan view of a SAW filter according to the present invention;
FIG. 2 is an enlarged cross-sectional view of an interdigital transducer portion in FIG. 1;
FIG. 3 is a drawing showing a general pattern of a mode coupled type SAW resonator filter;
FIG. 4 is a graph showing results of the first experimental example of the present invention where changes of the insertion loss of a SAW filter were measured by varying the thickness of a silicon oxide film on the electrodes;
FIG. 5 is a graph showing results of the second experimental example of the present invention where the frequency-passing characteristics of the SAW filter were measured by varying the thickness of the silicon oxide film on the electrodes;
FIG. 6 is a table showing results of the third experimental example where experiments concerning moisture resistance were carried out for filters of four types;
FIG. 7 is a drawing showing a state where a piezoelectric substrate is placed in a sputtering device so as to be inclined with respect to a sputtering target according to a sixth experimental example of the present invention;
FIG. 8 is a cross-sectional view in the case described in JP 61-136312A where an insulating film is deposited on interdigital transducers; and
FIG. 9 is a cross-sectional view in the case where the insulating film is deposited on the interdigital transducers shown in FIG. 8 so that the surface of the insulating film is flattened.

### BEST MODE FOR CARRYING OUT THE INVENTION

The present invention will be described in more detail below with reference to the accompanying drawings.

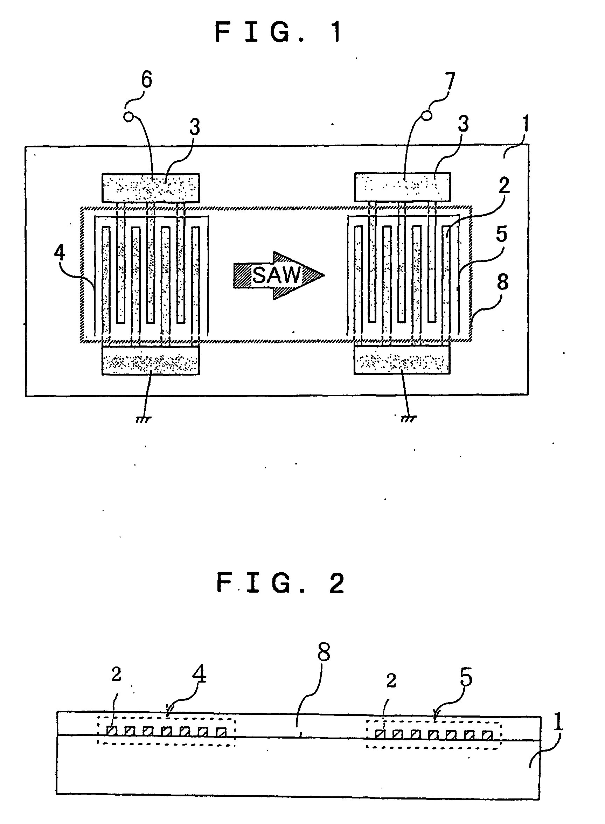

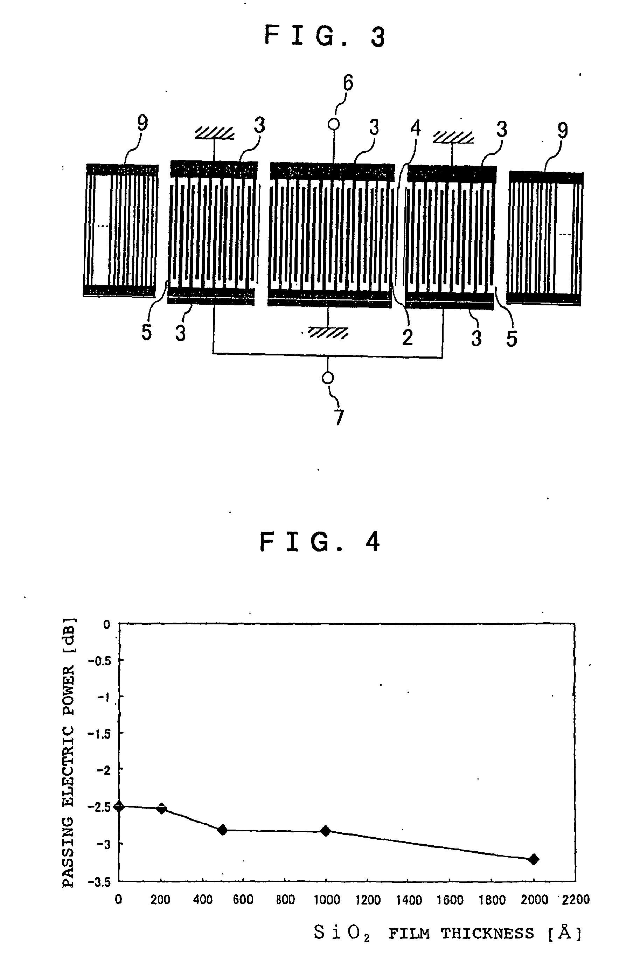

First, the structure and manufacturing method of a portion, in which a dielectric thin film is formed in an electrode portion, will be concretely described based on an example where the present invention is applied to a SAW filer. FIG. 1 is a plain view showing a structure of a transversal type SAW filter according to the present invention, while FIG. 2 is a magnified cross-sectional view of an interdigital transducer portion in FIG. 1. Also, FIG. 3 shows a general electrode pattern of a mode coupled type SAW resonator filter used in each experimental example to be described later. Note that it is enough that the structure and manufacturing method of a portion, in which a dielectric thin film is formed in an electrode portion, in the case of the transversal type SAW filer shown in FIGs. 1 and 2 are basically the same as those of the mode coupled type SAW resonator filter shown in FIG. 3. Therefore, in the following description, the case of the transversal type SAW filter shown in FIGs. 1 and 2 will be mainly explained and the description concerning the mode coupling SAW resonance filter shown in FIG. 3 is limited to a general electrode pattern only. Note that in FIGs. 1 to 3, the same portions are given the same reference numerals.

In FIGs. 1 to 3, reference numeral 1 denotes a piezoelectric substrate, numeral 2 an electrode finger, numeral 3 a lead-out electrode for supplying electric power to interdigital transducers 4 and 5, numeral 4 an input side interdigital electrode for performing energy conversion of from an electricity to a surface acoustic wave, numeral 5 an output side interdigital electrode for performing energy conversion of from a surface acoustic wave to an electricity, numeral 6 an input terminal, numeral 7 an output terminal, and numeral 8 a dielectric thin film. Also, in FIG. 3, reference numeral 9 represents a grating reflector.

A structure of an electrode portion of the SAW filter shown in FIG. 1 will be more concretely described below by following the steps for manufacturing the elastic wave device of the present invention. First, electrode patterns including the interdigital transducers 4 and 5 (in the case of the mode coupled type SAW resonator filter shown in FIG. 3, the grating reflector 9 is also included) are formed on the piezoelectric substrate 1 with a photolithography technique. The electrode finger width, electrode finger interval, and electrode film thickness are appropriately adjusted in accordance with an operating frequency band of the elastic wave device. Then, the dielectric thin film 8 made of silicon oxide is formed on the electrode patterns.

Next, only the dielectric thin film on the lead-out electrode for inputting or outputting electric power is removed through a photolithography process and wires for inputting or outputting electric power are connected to the lead-out electrode 3 and electrodes of the package, thereby forming the elastic wave device.

The elastic wave device shown in FIG. 1 is constructed in the manner described above. However, in some cases, after the electrode patterns including the interdigital transducers 4 and 5 (in the case of the mode coupled type SAW resonator filter shown in FIG. 3, the grating reflector 9 is also included) are formed, there may be added a step for further forming an electrode made of Al or an alloy including Al as its main ingredient only on a bus bar electrode connecting each space between the electrodes and in a portion of the lead-out electrode 3 for connecting wires for inputting or outputting electric power. By adding this step, the thicknesses of the bus bar electrode and lead-out electrode 3 are increased and the electric resistance of the bus bar electrode portion is thus reduced, whereby it becomes possible to obtain an elastic wave device with a further reduced loss. Also, it becomes easier to bond the wires for inputting or outputting electric power in an electrode pad portion.

Incidentally, this SAW filter shown in FIG. 1 operates as follows.

An electric signal applied to the input terminal 6 creates an electric field at each intersection of the input side interdigital transducers 4. The substrate 1 is made of a piezoelectric substance, so that distortion is caused by the aforementioned electric field during this operation. Also, in this SAW filter, there is obtained a structure where the dielectric thin film 8 is deposited on the interdigital transducers 4 and 5, so that the electric field applied to the interdigital electrodes 4 and 5 reaches the piezoelectric substrate 1 and the dielectric thin film 8 and a surface acoustic wave is excited and received. In the case where an input signal has a frequency f, the caused distortion also oscillates at the frequency f and becomes a SAW that will propagate in a direction parallel to the electrode fingers 2. Also, the output interdigital electrode 5 reconverts the SAW into an electric signal. The case where an electric signal is converted into a SAW and the case where a SAW is converted into an electric signal are processes that are reversible to each other.

The SAW filter according to the present invention is constructed as described above, although this filter is significantly affected by the condition of the surface of the substrate because a SAW propagates along the substrate surface. For instance, in the case where electrodes exist, a SAW is influenced by various effects such as a mass addition effect of the electrodes and an electric field short effect, so that the characteristics of the SAW greatly changes. Also, in the case where a thin film or the like is deposited on the substrate surface, the characteristics of the SAW changes in a like manner and therefore the characteristics of an elastic wave device also changes.

As described above, in the elastic wave device in which the electrodes including the interdigital transducers 4 and 5 are formed on the piezoelectric substrate 1, the insulating film 8 is deposited on these electrodes. As a result, it becomes possible to obtain an elastic wave device that is not required to be highly hermetically sealed in a package for the sake of protecting electrodes from minute metallic dusts and avoiding influences from the outside.

Next, there will be described experimental examples in which studies concerning the thickness of the dielectric thin film described above were conducted.

### First Experimental Example

In the first experimental example, the thickness of the dielectric thin film was studied from a viewpoint of the insertion loss of a SAW filter.

That is, as regards a SAW filter obtained by forming electrode patterns including interdigital transducers on a piezoelectric substance and then depositing a silicon oxide film thereon with a CVD (chemical vapor deposition) method, the value of the insertion loss was measured by changing the thickness of the dielectric thin film 8 made of silicon oxide. In more detail, the insertion loss of the SAW filter was measured by setting the thickness of the dielectric thin film 8 at 200, 500, 1000, and then 2000 Å. Also, as the SAW filter, there was used a filter having electrode patterns of the mode coupled type SAW resonator filter shown in FIG. 3. Note that in this FIG. 3, two output side interdigital transducers 4 and 5 was electrically connected in parallel. Also, as described above, reference numeral 9 denotes a gradating reflector.

Experimental results in this example are shown in FIG. 4. As can be seen from these results, the insertion loss of the SAW filter is increased in accordance with the increase of the thickness of the dielectric thin film 8. In FIG. 4, this insertion loss is calculated from the decreased amount of a passing electric power (dB). In the case where the thickness of the dielectric thin film 8 is 2000 Å, the insertion loss is increased by around 1 dB in comparison with the case where the dielectric thin film 8 is not provided, and this increased amount of the insertion loss cannot be regarded as negligible. The upper limit in a permissible range of the increased amount of the loss is around 0.5 dB, so that it may be judged that the upper limit of the thickness of the dielectric thin film 8 deposited on the SAW filter is 1000 Å. This may be because if the thickness of the dielectric thin film 8 is increased so as to exceed 1000 Å, the propagation attenuation of a surface acoustic wave is increased. Also, the SAW filter used for this measurement is a filter that has been designed to exhibit the most preferable characteristics when the dielectric thin film 8 is not provided. Accordingly, one- conceivable reason why the insertion loss is increased is that the electrode patterns do not necessarily satisfy optimum design conditions because the dielectric thin film 8 is deposited on the surface of the piezoelectric substrate 1. As described above, it was experimentally confirmed that almost no influence is exerted on the original characteristics of the elastic wave device if the thickness of the dielectric thin film 8 remains below around 1000 Å.

It should be noted here that if the thickness of the dielectric thin film 8 formed on electrodes is below 100 Å and thus too thin, the coating property of electrodes, such as the interdigital transducers 4 and 5 and reflection electrodes, with the dielectric thin film 8 is worsened.

Accordingly, from the results of the first experimental example, it can be said that the appropriate thickness of the dielectric thin film 8 is in a range of from 100 Å to 1000 Å.

As described above, in this first experimental example, in an elastic wave device in which electrodes including the interdigital transducers 4 and 5 made of a conductive material or the reflector 9 are formed on a piezoelectric substrate or the piezoelectric substrate 1 including a piezoelectric thin film, in the case where the dielectric thin film 8, whose thickness is in a range of from 100 to 1000 Å and which includes silicon oxide as its main ingredient, is formed on the interdigital transducers 4 and 5 and the reflector 9, it becomes possible to realize an elastic wave device in which there occurs less insertion loss, and moisture resistance is enhanced and the manufacturing cost is reduced in comparison with a conventional elastic wave device of this type.

### Second Experimental Example

In this second experimental example, in an elastic wave device obtained by forming electrode patterns including the interdigital transducers 4 and 5 on a piezoelectric substrate, the dielectric thin film 8 including silicon oxide as its main ingredient was deposited on the electrode patterns. Then, changes of the characteristics of the elastic wave device were measured by changing the thickness of this dielectric thin film 8. In this example, the measurement was performed using the mode coupled type SAW resonator filter in FIG. 3, like in the above example.

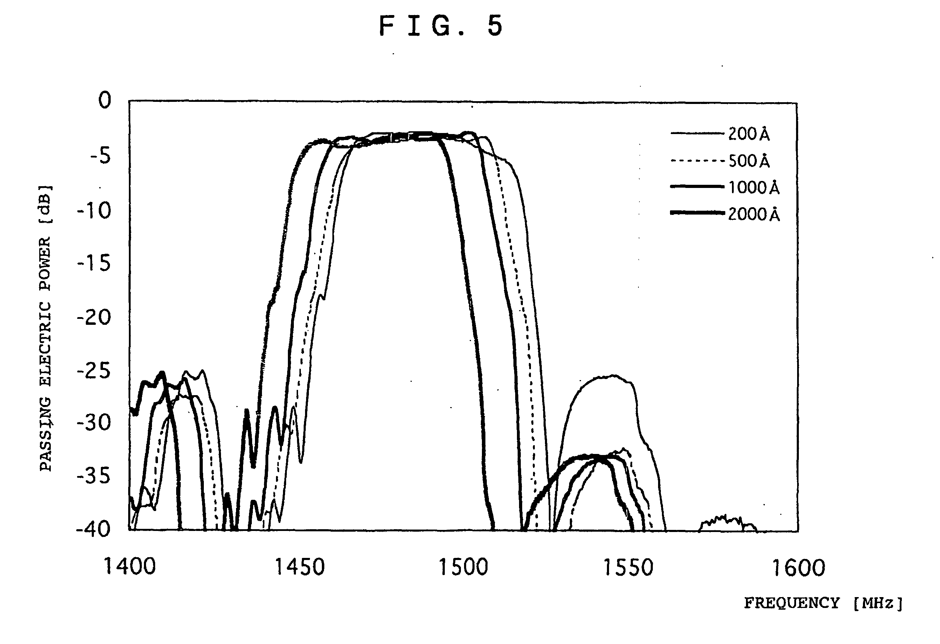

FIG. 5 shows results of this second experimental example.

In FIG. 5, the center frequency of a pass band of filter characteristics is gradually lowered in accordance with the increase of the thickness of the dielectric thin film 8. Also, the insertion loss is increased and the bandwidth is decreased. In the case where the thickness of the dielectric thin film 8 remains below around 1000 Å, it is possible to roughly reproduce the original characteristics of an elastic wave device in which a SAW filter is optimally designed. However, if the thickness of the dielectric thin film is increased to 2000 Å, the resonant resistance of the elastic wave device in the GHz band used for mobile wireless communications is increased. Accordingly, it becomes difficult to recover the characteristics of the elastic wave device, which have been degraded by the deposition of the dielectric thin film 8 on the elastic wave device, through some suitable designing. Also, because it is preferable that the variations in the center frequency be small if possible, the variations in the center frequency are preferably below 5 MHz. Accordingly, it is desired that the thickness of the dielectric thin film 8 remains below 500 Å.

It should be noted here that because it is preferable that the variations in the center frequency be as small as possible, it is preferable that the thickness of the dielectric thin film 8 made of silicon oxide be small from this viewpoint. However, if the thickness is excessively thin, the coating ratio of the electrode patterns by the silicon oxide film is worsened and it becomes impossible to obtain a sufficient effect of improving the moisture resistance. Accordingly, it is required that the dielectric thin film 8 made of silicon oxide has a thickness that is equal to or larger than 100 Å, as described above.

As described above, in this second experimental example, in an elastic wave device in which electrodes including the interdigital transducers 4 and 5 made of a conductive material or the reflector 9 are formed on a piezoelectric substrate or the piezoelectric substrate 1 including a piezoelectric thin film, in the case where the dielectric thin film 8, whose thickness is in a range of from 100 to 500 Å and which includes silicon oxide as its main ingredient, is formed on the interdigital transducers 4 and 5 and the reflector 9, it becomes possible to realize an elastic wave device in which the changes of the center frequency are suppressed, and moisture resistance is enhanced and the manufacturing cost is reduced in comparison with a conventional elastic wave device of this type.

### Third Experimental Example

In a third experimental example, experiments concerning moisture resistance were conducted for four types of SAW filters. In an elastic wave device in which electrode patterns including interdigital transducers were formed on a piezoelectric substrate, in the case where the dielectric thin film 8 including silicon oxide as its main ingredient was deposited on the electrode patterns with a CVD method, there were changed the cross-sectional shape of the electrodes, the thicknesses of electrode films, and the thickness of the dielectric thin film. The filter in FIG. 3 was used as the SAW filters.

In the SAW filter of type 1, electrodes were formed using a contact exposure machine and wet etching. In the SAW filters of other types, electrodes were formed using a reduced exposure machine and dry etching. Here, the contact exposure machine means a device that performs exposure with a photolithography technique by directly bringing a mask, on which the electrode patterns have been drawn, into close contact with a piezoelectric substrate wafer. On the other hand, the reduced exposure machine means a device that performs exposure by reducing the size of the patterns drawn on a mask to 1/5, 1/10, or the like by arranging the mask, on which the electrode patterns have been drawn, so that a certain distance is maintained with a piezoelectric substrate wafer.

Also, this elastic wave device is contained in a simple package whose material is not a ceramic, and the lid of the package is sealed with a resin exhibiting a permeable property to moisture. Under this condition, the elastic wave device was installed in an environment where the temperature was 85°C and the humidity was 85%, thereby measuring the characteristics of the filter after a certain time has passed.

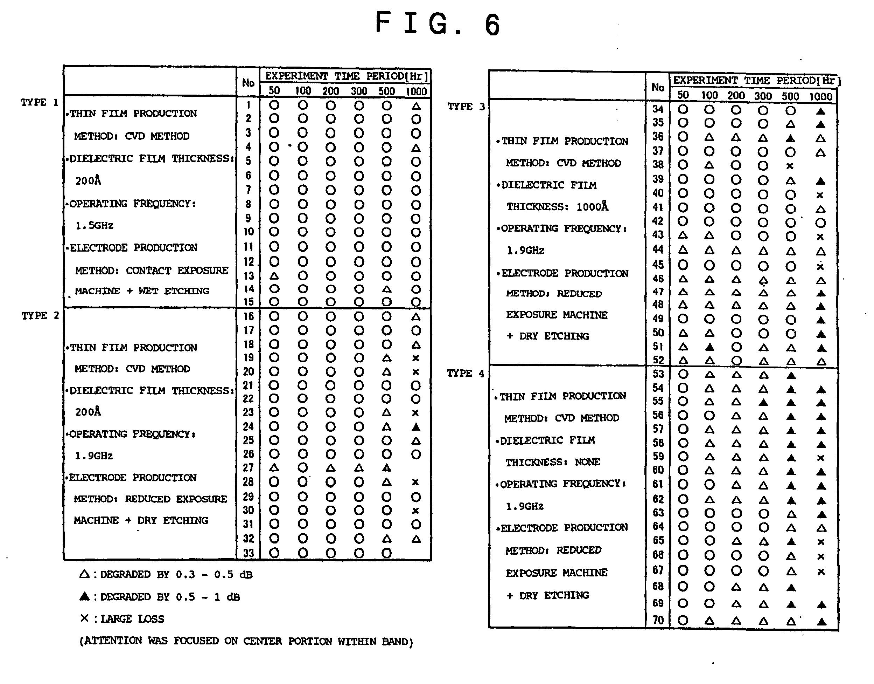

FIG. 6 is a table showing results of the third experimental example where experiments concerning moisture resistance were conducted for these four types.

As is apparent from the results shown in FIG. 6, the type 1, out of these four types, produced the best result. On the other hand, the type 4 produced the worst result. In the case of the type 4 where the dielectric thin film 8 was not provided on the electrode patterns, the characteristics of the elastic wave device started to be degraded when about 100 hours had passed. In the case of other three types where the dielectric thin film 8 was provided on the electrode patterns, no degradation was observed for the characteristics of the elastic wave device even after about 100 hours had passed. As to the type 1 and type 2, both of these types have the same thickness of the dielectric thin film 8, i.e., 200 Å, but have different shapes of electrodes. That is, when the cross sections of electrodes are compared, the type 1 has a trapezoidal shape but the type 2 has a rectangular shape. Also, the shapes of the cross sections of the electrodes of the types 1 and 2 were observed using a scanning electron microscope (hereinafter referred to as SEM). As a result of this observation, it was found that in the case of the type 1 using the electrodes having the trapezoidal cross-sectional shape, the dielectric thin film 8 covering the electrode finger 2 had an even thickness. However, in the case of the type 2 using the electrodes having the rectangular cross-sectional shape, there were found some portions where the side surfaces of the electrode fingers 2 were not evenly covered with the dielectric thin film 8. It is conceived that this difference in the coating condition of the dielectric thin film 8 causes the difference in experimental result between the type 1 and the type 2. Also, in the case of the type 3 where the thickness of the dielectric thin film 8 was set at 1000 Å, different experimental results were obtained for respective specimens. When observation was carried out using the SEM, good experimental results were obtained from specimens where the electrode patterns were covered with the dielectric thin film 8 with an even thickness, while unfavorable experimental results were obtained from specimens where the electrode fingers 2 were not evenly covered with the dielectric thin film 8. However, it is revealed that even in the case where thickness of the dielectric thin film 8 is 1000 Å, it is possible to obtain specimens with a good coating condition of the dielectric thin film. As a result, it is conceived that by appropriately setting the film forming condition for the dielectric thin film 8, the electrode finger 2 is evenly covered with the dielectric thin film 8 and therefore the moisture resistance is improved.

From the experimental results described above, it becomes clear that in the case where the dielectric thin film 8 including silicon oxide as its main ingredient is deposited on electrode patterns in an elastic wave device in which the electrode patterns including the interdigital transducers 4 and 5 are formed on the piezoelectric substrate 1, the dielectric thin film 8 having a thickness of from 200 to 1000 Å does not affect the characteristics of the elastic wave device but the moisture resistance is improved.

It should be noted here that experiments concerning the moisture resistance were conducted only in the case of the dielectric thin film 8 having a thickness of equal to or larger than 200 Å. However, even if the thickness of the dielectric thin film is smaller than 200 Å, it is conceived that there is obtained an effect of improving the moisture resistance in comparison with the case where the dielectric thin film is not provided and electrode films are unprotected.

Even in the case where the thickness of the dielectric thin film is 200 Å or less, however, the moisture resistance is improved in comparison with an elastic wave device in which the dielectric thin film 8 is not provided and electrodes are unprotected, whereas the coating ratio of the side surfaces of electrodes is worsened. Therefore, it is not ensured that a sufficient moisture resistance is obtained at all times. Consequently, it may be the most preferable that the thickness of the dielectric thin film is in a range of from 200 to 500 Å.

As described above, in this third experimental example, in an elastic wave device in which electrodes including the interdigital transducers 4 and 5 made of a conductive material or the reflector 9 are formed on a piezoelectric substrate or the piezoelectric substrate 1 including a piezoelectric thin film, in the case where the dielectric thin film, whose thickness is in a range of from 200 to 500 Å and which includes silicon oxide as its main ingredient, is formed on the interdigital transducers 4 and 5 and the reflector 9, it becomes possible to realize an elastic wave device in which moisture resistance is enhanced and the manufacturing cost is reduced in comparison with a conventional elastic wave device of this type.

Also, the moisture resistance of the elastic wave device is improved, so that it becomes unnecessary to highly hermetically seal the elastic wave device in a package and it becomes possible to use a simple package in place of a ceramic package. As a result, it becomes possible to reduce the manufacturing cost.

Also, in this third experimental example, in an elastic wave device in which electrodes including the interdigital transducers 4 and 5 made of a conductive material or the reflector 9 are formed on a piezoelectric substrate or the piezoelectric substrate 1 including a piezoelectric thin film, in the case where the dielectric thin film 8 including silicon oxide as its main ingredient is formed on the interdigital transducers 4 and 5 and the reflector 9, it becomes possible to realize an elastic wave device in which the coating ratio of the electrode finger 2 with the dielectric thin film 8 is improved, moisture resistance is enhanced, and the manufacturing cost is reduced in comparison with a conventional elastic wave device of this type. To do so, the electrode fingers 2 that are made of a conductive material and constitute the interdigital transducers 4 and 5 and the reflector 9 have a cross-sectional shape that is a trapezoid when taken along a plane that is parallel to a direction vertical to the substrate surface, and in a direction perpendicular to a crossing width direction thereof.

### Fourth Experimental Example

In a fourth experimental example, differences resulting from using different methods for manufacturing the dielectric thin film 8 were considered.

In more detail, the aforementioned experiments concerning the moisture resistance were conducted for dielectric thin films 8 produced with a sputtering method and a coating method as well as for the dielectric thin film 8 produced with the CVD method. As a result of the experiments, in the case of the dielectric thin film produced with the sputtering method, there were obtained approximately the same experimental results as in the case of the dielectric thin film produced with the CVD method. However, in the case of the coating method, the coating condition of electrodes with the silicon oxide film was bad and therefore the experimental results were not so good.

As described above, in this fourth experimental example, in an elastic wave device in which electrodes including the interdigital transducers 4 and 5 made of a conductive material or the reflector 9 are formed on a piezoelectric substrate or the piezoelectric substrate 1 including a piezoelectric thin film, in the case where the dielectric thin film 8, whose thickness is in a range of from 100 to 1000 Å and which includes silicon oxide as its main ingredient, is formed on the interdigital transducers 4 and 5 and the reflector 9, it becomes possible to realize an elastic wave device in which moisture resistance is enhanced and the manufacturing cost is reduced in comparison with a conventional elastic wave device of this type. To do so, the dielectric thin film 8 is produced with the CVD method or the sputtering method. Also, it has been made clear that a silicon oxide film produced with the sputtering method also has a sufficient moisture resistance.

### Fifth Experimental Example

A fifth experimental example relates to the improvements of the manufacturing method utilizing the sputtering method in the case where the cross-sectional shape of electrodes is rectangle.

From the results of experiments on moisture resistance shown in FIG. 6, it has been found that in the case where the electrodes have the rectangular cross-sectional shape, the adhesion ratio of the dielectric thin film to the side surfaces of the electrodes is reduced in comparison with the case of the trapezoid cross-sectional shape. This is because with a thin film production method like the sputtering method, the sputtered atoms of a thin film material have a large kinetic energy with respect to a traveling direction thereof, that is, a piezoelectric substrate direction and is incident on the substrate from a direction that is almost vertical to the surface of the substrate. In this case, thin film molecules do not directly reach a plane vertical to the substrate surface, that is, the side surfaces of the electrodes. In the case where the temperature of the substrate is appropriately controlled, the thin film molecules reaching the upper surfaces of the electrodes or the surface of the piezoelectric substrate 1 receive thermal energy from the piezoelectric substrate 1, move to the side surfaces of the electrodes, and adhere thereto. However, it is not necessarily ensured that the side surfaces of any electrodes are sufficiently covered with the thin film molecules at all times.

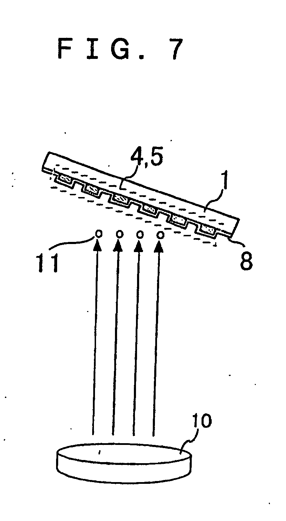

As described above, in the case of an ordinary sputtering method where the piezoelectric substrate is arranged vertically to a sputtered atom target, there occur the aforementioned problems. Therefore, in the case where the piezoelectric substrate 1, on which electrode patterns including the interdigital transducers 4 and 5 have been formed, is placed in a sputtering device, the piezoelectric substrate 1 is placed so as to be inclined with respect to a sputtering target 10, as shown in FIG. 7. The piezoelectric substrate 1 is rotated while being inclined with respect to the sputtering target 10. By doing so, it becomes possible to improve the adhesion ratio of the dielectric thin film 8 to the electrode side surfaces on which it is difficult to deposit the dielectric thin film. Note that in FIG. 7, reference numeral 11 denotes ionized particles and the solid arrows show the direction in which the sputtered particles 11 are emitted.

As described above, in this fifth experimental example, in an elastic wave device in which electrodes including the interdigital transducers 4 and 5 made of a conductive material or the reflector 9 are formed on a piezoelectric substrate or the piezoelectric substrate 1 including a piezoelectric thin film, in the case where the dielectric thin film 8 including silicon oxide as its main ingredient is formed on the interdigital transducers 4 and 5 and the reflector 9 with the sputtering method, it becomes possible to realize an elastic wave device in which moisture resistance is enhanced and the manufacturing cost is reduced in comparison with a conventional elastic wave device of this type. To do so, the piezoelectric substrate 1 is placed so as to be inclined with respect to the sputtering target 10 and is then rotated while being thus inclined relative to the sputtering target 10, thereby depositing the dielectric thin film 8 from a direction that is inclined from a direction vertical to the substrate surface.

As described above, with the technique of the present invention, in an elastic wave device in which electrodes including the interdigital transducers 4 and 5 made of a conductive material are formed on the piezoelectric substrate 1, the dielectric thin film 8 including silicon oxide as its main ingredient is deposited on the interdigital transducers 4 and 5 and the reflector 9, with the thickness of this dielectric thin film 8 being appropriately set. In the case where the thickness of the dielectric thin film 8 is appropriately set based on each experimental example, it becomes possible to protect the electrodes from moisture without a package that is generally required with a conventional elastic wave device. As a result, it becomes possible to reduce the manufacturing cost and to realize the integration with a semiconductor element.

Also, it is known that it is possible to set the temperature coefficient of an elastic wave device at zero by depositing a silicon oxide thin film on a substrate. In this case, however, it is required to set the thickness of the silicon oxide thin film so as to be much larger than the intervals between the electrode fingers. This results in the increase of the propagation loss and therefore such an elastic wave device is not yet realized as a product. However, even with the dielectric thin film 8 having the thickness described in the experimental examples of the present invention, a slight improvement in the temperature characteristic can be attained.

Also, it is possible to expect improved electromechanical coupling coefficient K² by depositing the dielectric thin film 8 on the piezoelectric substrate 1.

Further, by depositing the dielectric thin film 8 on the piezoelectric substrate 1, the peripheries of electrodes are surrounded by the dielectric thin film 8, so that it is also possible to expect improved electric power resistance.

Also, as has conventionally been said, each piezoelectric material has a pyroelectric effect, which induces electrical charges on the surface of the piezoelectric material. Then, these electrical charges cause electric discharge between the electrode fingers 2 and between the reflector 9 and the electrode fingers 2. This electric discharge often destroys the electrodes or causes noises during when it is taking place, which degrades the characteristics of an elastic wave device. However, with the present invention, there is obtained a structure where the dielectric thin film 8 is deposited on the electrodes. With this structure, the electrical charges induced by a pyroelectric effect on the surface of the piezoelectric substrate 1 are emitted to the outside without localizing at a certain location on the surface of the piezoelectric substrate 1. As a result, it becomes possible to avoid the electric discharge described above.

It should be noted here that in the above description, there have been explained, as examples, the transversal type filter in FIG.1 and the SAW resonator filter in FIG. 3. However, the present invention is not limited to these and the same effects as above are obtained even if the present invention is applied to a filter having a multi-electrode structure, a ladder type filter in which SAW resonators are connected in multiple stages.

Further, the same effects as obtained in the above-described case where the arrangement pitches of the electrode fingers 2 are all set to be the same in the interdigital transducers 4 and 5, can be also attained in the case where some or all of the arrangement pitches are changed. Also, each effect described above is similarly obtained even in the case where floating electrodes are provided in the interdigital transducers 4 and 5 or in the case of an arrangement where floating electrodes existing at different locations of the interdigital transducers 4 and 5 are electrically connected to each other.

Also, there has been described the case where all of the arrangement pitches of the reflector electrodes 9 are the same, although the same effects are obtained even in the case where some or all of the arrangement pitches are changed. Also, each effect described above is similarly obtained even in the case where floating electrodes are provided in the reflector electrodes 9 or in the case of an arrangement where floating electrodes existing at different locations of the reflector electrodes 9 are electrically connected to each other.

Further, in the above description, the present invention is applied to a SAW filter. However, the same effects are achieved even if the present invention is applied to any other SAW device in which there are formed interdigital transducers having a function of performing the conversion between a SAW and an electrical signal of one-terminal pair SAW resonator, a SAW delay line, a SAW dispersive delay line, a SAW convolver, or the like. Also, the same effects are obtained for all of elastic wave devices that use these SAW devices.

### INDUSTRIAL APPLICABLILITY

As described above, it is possible to suitably use the elastic wave device according to the present invention in many fields such as a video intermediate filter for a television receiver (PIF), a vestigial side band filter (VSBF) for a television broadcasting equipment, an RF converter resonator for a VTR, and a frequency converter resonator for a CATV receiver.

## Claims

1. An elastic wave device in which electrodes including interdigital transducers made of a conductive material are formed on a piezoelectric substrate, comprising a dielectric thin film formed on said interdigital transducers, said dielectric thin film having a thickness of from 100 to 1000 Å and including silicon oxide as its main component.

2. An elastic wave device in which electrodes including interdigital transducers made of a conductive material are formed on a piezoelectric substrate, comprising a dielectric thin film formed on said interdigital transducers, said dielectric thin film having a thickness of from 100 to 500 Å and including silicon oxide as its main component.

3. An elastic wave device in which electrodes including interdigital transducers made of a conductive material are formed on a piezoelectric substrate, comprising a dielectric thin film formed on said interdigital transducers, said dielectric thin film having a thickness of from 200 to 500 Å and including silicon oxide as its main component.

4. An elastic wave device according to claim 1, 2, or 3, **characterized in that** said dielectric thin film is formed with a CVD method.

5. An elastic wave device according to claim 1, 2, or 3, **characterized in that** said dielectric thin film is formed with a sputtering method.

6. An elastic wave device according to claim 5, **characterized in that** said dielectric thin film is deposited by placing said piezoelectric substrate or a substrate including a piezoelectric thin film so as to be inclined with respect to a sputtering target and by sputtering said dielectric thin film from a direction that is inclined with respect to a direction vertical to the surface of said substrate.

7. An elastic wave device according to any one of claims 1 to 6, **characterized in that** electrode fingers that are made of a conductive material and constitute said electrodes including the interdigital transducers have a cross-sectional shape that is a trapezoid when taken along a plane that is parallel to the direction vertical to the surface of said substrate, and in a direction vertical to a crossing width direction thereof.
